# EUROPÄISCHE PATENTSCHRIFT

(11) **EP 4 114 150 B1**
(45) Veröffentlichungstag und Bekanntmachung des Hinweises auf die Patenterteilung: **12.08.2026**
(21) Anmeldenummer: 22174575.5
(22) Anmeldetag: 20.05.2022
(51) Int. Cl.: H05K 5/00, H05K 5/02, H05K 7/18, H05K 5/30, H02B 1/30, H02B 1/01

(54) **ERWEITERUNGSBAUSATZ**
EXPANSION BUILDING SET
ENSEMBLE D'EXTENSION

(30) Priorität: 30.06.2021 DE 102021116812
(43) Veröffentlichungstag der Anmeldung: 04.01.2023
(73) Patentinhaber: Vertiv S.r.l., 35028 Piove di Sacco, (PD) (IT)
(72) Erfinder: RÖHRL, Max, 94428 Eichendorf (DE); KALTENBERGER, Alfons, 94436 Simbach (DE); SCHNEIDERBAUER, Siegfried, 94439 Roßbach (DE)
(74) Vertreter: Wunderlich & Heim Patentanwälte PartG mbB

(56) Entgegenhaltungen:
- WO-A2-2008/110391
- CN-U- 201 709 043
- DE-U1- 20 118 727
- US-A1- 2004 080 244
- US-A1- 2011 115 345

## Beschreibung

Die Erfindung betrifft einen Erweiterungsbausatz für einen IT-Geräteschrank.

IT-Geräteschränke werden beispielsweise in Rechenzentren eingesetzt, um darin Geräte der IT-Technik unterzubringen. Beispiele hierfür sind Server, Netzwerkkomponenten oder auch unterbrechungsfreie Stromversorgungen.

Es ist üblich, dass Rechenzentren mit entsprechenden IT-Geräteschränken ausgestatten sind, in die je nach Anwendungszweck IT-Geräte beziehungsweise IT-Komponenten eingebaut werden. Da IT-Geräteschränke eine deutlich längere Lebensdauer als die IT-Geräte selbst haben, kann es vorkommen, dass die Schänke nicht mehr die notwendige Maße haben, um neue IT-Geräte aufzunehmen. Auch kann es beispielweise notwendig sein, dass zusätzliche Geräte in einem IT-Geräteschrank aufgenommen werden müssen. Ein Beispiel hierfür ist eine größere und unterbrechungsfreie Stromversorgung oder eine zusätzliche Netzwerkkomponente.

Bisher musste in diesem Fall oft der IT-Geräteschrank ersetzt, was mit erhöhten Kosten und Aufwand verbunden ist.

Aus der CN 201 709 043 U ist ein Erweiterungsbausatz für einen IT-Geräteschrank mit den Merkmalen des Oberbegriffs des Patentanspruches 1 bekannt.

Der Erfindung liegt daher die Aufgabe zugrunde, eine Möglichkeit anzugeben, IT-Geräteschränke zu vergrößern.

Diese Aufgabe wird erfindungsgemäße durch einen Erweiterungsbausatz für einen IT-Geräteschrank mit den Merkmalen des Anspruchs 1 gelöst.

Bevorzugte Ausführungsformen der Erfindung sind in den Unteransprüchen, in der Beschreibung sowie in den Figuren und deren Erläuterung angegeben.

Der erfindungsgemäße Erweiterungsbausatz für ein IT-Geräteschrank weist zwei Vertikalprofile, zwei Querprofile sowie vier Tiefenprofile auf. Hierbei bilden die zwei Vertikalprofile und die zwei Querprofile einen rechteckigen Rahmen aus, wobei zwei untere und zwei obere Kontaktbereiche zwischen je einem Vertikalprofil und einem Querprofil ausgebildet sind. Diese Kontaktbereiche liegen in den Ecken des jeweiligen Rahmens.

Jedes der Tiefenprofile ist mit einem seiner zwei Enden an einem der vier Kontaktbereiche befestigt. Ferner sind zwei Adapterprofile vorgesehen, wobei je ein Adapterprofil parallel zu je einem Vertikalprofil an dem anderen Ende von zwei Tiefenprofilen befestigt ist. Die Adapterprofile dienen zur Befestigung an einem IT-Gerätschrank und sind entsprechend ausgebildet.

Entsprechend der Erfindung wurde erkannt, dass es vorteilhaft ist, keinen neuen IT-Geräteschrank zu bereitzustellen, sondern vorhandene IT-Geräteschrankes zu erweitern. Hierfür wird die zugrunde liegende Konstruktion eines IT-Geräteschrankes wiederum aufgenommen, so dass der Erweiterungsbausatz im Wesentlichen eine quaderförmige Außenstruktur hat. Es fehlen jedoch zwei Querprofile.

Die notwendige Stabilität erhält der Erweiterungsbausatz dadurch, dass die Adapterprofile mit dem IT-Geräteschrank verbunden werden. Insofern bilden die zwei dem Erweiterungsbausatz zugewandten Querprofile des IT-Geräteschrankes auch die notwendigen Querprofile für den Erweiterungsbausatz, um eine ausreichende Stabilität zu gewährleisten.

Vorteilhaft ist es, wenn der Querschnitt der Vertikalprofile und der Querschnitt der Querprofile gleich ist. Anders ausgedrückt, können dieselben Profile mit unterschiedlichen Längen verwendet werden. Dies erleichtert die Lagerhaltung und ermöglicht auch einen flexiblen Aufbau.

Die Kontaktbereiche können beliebig ausgeführt sein. Vorteilhaft ist es, wenn je ein identischer Eckverbinder vorgesehen ist. Dieser Eckverbinder ist so ausgestaltet, dass er je eine Aufnahme oder Verbindungsbereich für ein Vertikalprofil, für ein Querprofil und für ein Tiefenprofil aufweist. Haben die Vertikal- und Querprofile dasselbe grundlegende Profil, so können identische Eckverbinder für alle vier Kontaktbereiche eingesetzt werden.

Grundsätzlich können die Vertikalprofile, die Querprofile und/oder die Tiefenprofile mittels beliebiger Befestigungsmitteln an den Eckverbindern beziehungsweise miteinander verbunden sein. Bevorzugt ist hierbei eine lösbare Befestigung, beispielsweise in Form einer Schraube oder einer Klemmverbindung.

Die Adapterprofile sind bevorzugt so ausgeführt, dass sie mit den Vertikalprofilen des IT-Geräteschrankes korrespondieren, das heißt eine Befestigung an diesen ermöglichen. Hierfür weisen die Adapterprofile erfindungsgemäß mindestens in ihrem Anfangs- und Endbereich einen S-förmigen, gespiegelten S-förmigen, U-förmigen oder C-förmigen Querschnitt auf. In diesen Bereichen können sie an die entsprechenden Eckverbinder des IT-Geräteschrankes angebracht werden.

Der S-förmige oder der gespiegelte S-förmige Querschnitt des Adapterprofils kann beispielsweise ein Innen- und zwei Außenschenkel sowie zwei Verbindungsschenkel aufweisen. Hierbei kann ein erstes Ende des ersten äußeren Schenkels mittels des ersten Verbindungsschenkels mit einem ersten Ende des inneren Schenkels verbunden sein. Ein zweites Ende des inneren Schenkels kann mittels des zweiten Verbindungsschenkels mit einem ersten Ende des zweiten äußeren Schenkels verbunden sein.

Der U-förmige oder der C-förmige Querschnitt des Adapterprofils kann beispielsweise zwei Außenschenkel sowie einen Verbindungsschenkel aufweisen. Hierbei kann ein erstes Ende des ersten äußeren Schenkels mittels des Verbindungsschenkels mit einem ersten Ende des zweiten äußeren Schenkels verbunden sein.

In den beiden äußeren Schenkeln können Befestigungsöffnungen vorgesehen sein. Diese dienen beispielsweise zum einen dazu, das Adapterprofil an den IT-Geräteschrank zu befestigen und zum anderen, um das Adapterprofil an den Tiefenprofilen des Erweiterungsbausatzes zu befestigen.

Hierfür ist es vorteilhaft, wenn die Verbindungsschenkel derartig dimensioniert sind, dass sie einen Zugriff auf die Befestigungsöffnungen der äußeren Schenkel gestatten. Die Dimensionierung ist hierbei derart, dass es möglich ist, Schrauben einzuführen und anzuziehen, um den Erweiterungsbausatz mittels des Adapterprofils an den IT-Geräteschrank beziehungsweise die Adapterprofile an den Tiefenprofile anzubringen.

Die Flexibilität des Erweiterungsbausatzes wird weiter erhöht, wenn das Adapterprofil zumindest zwischen seinem Anfangs- und Endbereich Befestigungslöcher zum Befestigen von IT-Geräten aufweist. Diese können insbesondere einen Abstand nach dem HE-Standard aufweisen. Somit ist es möglich, in den Erweiterungsbausatz ebenfalls IT-Geräte einzubauen, die auf der einen Seite an dem Adapterprofil und auf der anderen Seite an entsprechenden T-Nuten oder Befestigungsmitteln an den Vertikalprofilen befestigbar sind.

Ferner betrifft die Erfindung einen IT-Geräteschrank mit vier Vertikalschrankprofilen, mit vier Querschrankprofilen sowie vier Tiefenschrankprofilen. Diese bilden zusammen mit acht bevorzugten identischen Eckverbindungen eine quaderförmige Rahmenstruktur des IT-Geräteschrankes aus.

Der erfindungsgemäße IT-Gerätschrank weist einen entsprechenden Erweiterungsbausatz, wie zuvor erläutert, auf, welcher mittels der Adapterprofile an vier Eckverbindern einer Front oder Rückseite des IT-Geräteschrankes befestigt ist. Auf diese Weise ist es möglich, den Raum, der von einem IT-Geräteschrank zur Verfügung gestellt wird, einfach und effizient zu vergrößern. Grundsätzlich kann der Erweiterungsbausatz auch an einer der Seiten angebracht sein.

Bevorzugt ist es, dass die Vertikalprofile und die Vertikalschrankprofile einen gleichen Querschnitt aufweisen. Es ist auch möglich, dass zusätzlich oder alternativ die Querprofile und die Querschrankprofile einen gleichen Querschnitt aufweisen. Analog können auch die Tiefenprofile und die Tiefenschrankprofile einen gleichen Querschnitt aufweisen. Des Weiteren ist es bevorzugt, wenn die Eckverbinder des IT-Geräteschrankes sowie des Erweiterungsbausatzes identisch ausgeführt sind.

Durch eine derartige Dimensionierung und Konstruktion wird erreicht, dass Bauteile, die für den IT-Gerätschrank selbst entwickelt wurden, auch in den Erweiterungsbausatz integriert werden können. Dies betrifft beispielsweise Seitenverkleidungen, Türen, aber auch Aufnahmeböden oder dergleichen, welche im Innenraum montierbar sind.

Die Erfindung wird nachfolgend anhand eines schematischen Ausführungsbeispiels unter Bezugnahme auf die Figuren näher erläutert. Hierbei zeigen:
- Fig. 1: eine perspektivische Ansicht des erfindungsgemäßen Erweiterungsbausatzes;
- Fig. 2: einen IT-Geräteschrank mit erfindungsgemäßem Erweiterungsbausatz;
- Fig. 3: einen erfindungsgemäßen Erweiterungsbausatz in einer teilweisen Explosionszeichnung;
- Fig. 4: einen Querschnitt im Bereich eines Adapterprofils;
- Fig. 5: eine Vergrößerung des Bereiches V aus Fig. 3; und
- Fig. 6: eine Vergrößerung des Bereiches VI aus Fig. 3.

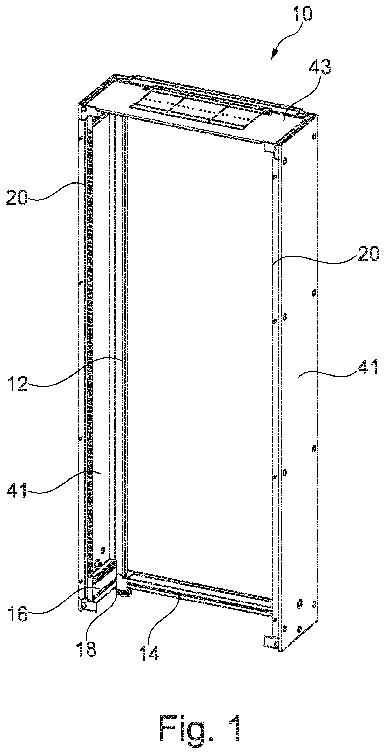

In Fig. 1 ist eine perspektivische Ansicht eines erfindungsgemäßen Erweiterungsbausatzes 10 für einen IT-Geräteschrank 70 dargestellt. Der Erweiterungsbausatz 10 besteht im Wesentlichen aus zwei Vertikalprofilen 12, zwei Querprofilen 14 und vier Tiefenprofilen 16.

Je ein Vertikalprofil 12, ein Querprofil 14 sowie ein Tiefenprofil 16 sind mit einem Eckverbinder 18 in einem Kontaktbereich verbunden. An zwei Tiefenprofilen 16 ist je ein Adapterprofil 20 befestigt, so dass es sich im Wesentlichen parallel zu einem Vertikalprofil 12 erstreckt.

In der hier dargestellten Ausführungsform sind die beiden Seiten mit entsprechenden Verblendungen 41 verschlossen. Diese können auch als Seitenwände bezeichnet werden. Die Verblendungen 41 können an den Vertikalprofilen, den Tiefenprofilen und/oder an dem Adapterprofil 20 befestigt werden. Analog ist auch eine Abdeckung 43 vorgesehen, welche den Erweiterungsbausatz 10 nach oben abschließt. Diese kann wiederum an den entsprechenden Tiefenprofilen 16 und den Querprofilen 14 befestigt werden.

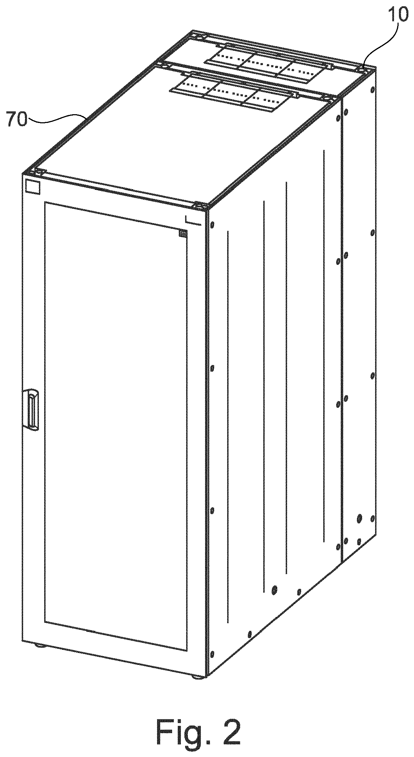

In Fig. 2 ist zur Übersicht ein Erweiterungsbausatz 10 gezeigt, welcher mit einem IT-Geräteschrank 70 verbunden ist. Hierdurch entstehe ein größerer Innenraum, in dem zusätzliche IT-Geräte aufgenommen werden. Wie dargestellt, verlängert der Erweiterungsbausatz 10 den IT-Geräteschrank 70 auch optisch und ohne Kanten auszubilden, da der Erweiterungsbausatz 10 im Wesentlichen dieselbe Höhe und Breite wie der IT-Geräteschrank 70 besitzt. Hierbei können die Vertikalprofile 12 und die Querprofilen 14 des Erweiterungsbausatz 10 mit denen des IT-Geräteschrank 70 identisch sein. Also beispielsweise dasselbe Profil und dieselbe Länge aufweisen.

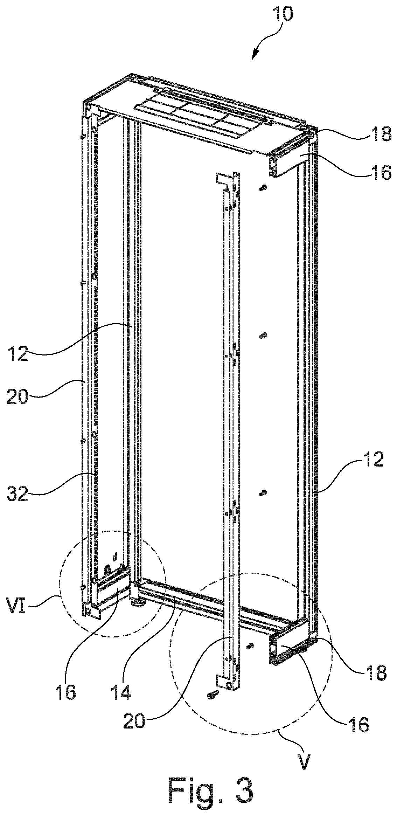

In Fig. 3 ist analog zu Fig. 1 der Erweiterungsbausatzes 10 dargestellt. Hierbei ist eines der Adapterprofile 20 vom Erweiterungsbausatz 10 entfernt gezeigt. Wie insbesondere aus dieser Darstellung hervorgeht, sind an den Adapterprofilen 20 zwischen den beiden Endbereichen entsprechende Befestigungslöcher 32 vorgesehen, welche insbesondere einen Abstand aufweisen, damit IT-Geräte nach dem HE-Standard befestigt werden können. Eine solche Befestigung findet zwischen den Adapterprofilen 20 und den entsprechenden Vertikalprofilen 12 statt, welche beispielsweise eine T-Nut aufweisen, die zur Befestigung dienen kann.

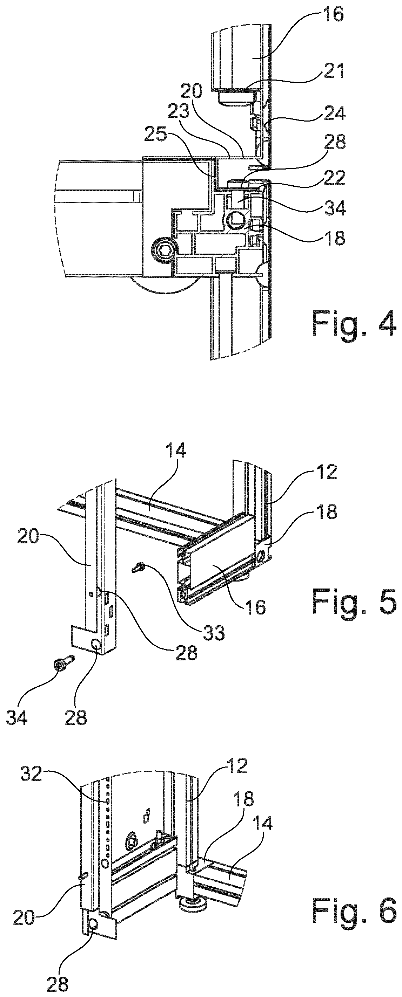

Fig. 4 zeigt einen Querschnitt durch den Kontaktbereich zwischen dem erfindungsgemäßen Erweiterungsbausatz 10 und dem IT-Geräteschrank 70, insbesondere ist hier der Eckverbinder 18 des IT-Geräteschrankes 70 gezeigt.

An diesen schließt sich das Adapterprofil 20 an, welches eine S-förmige Form hat. Diese Form wird durch einen ersten äußeren Steg 21 gebildet, an dem sich ein erster Verbindungssteg 24 anschließt. Am Ende dieses ersten Verbindungssteges 24 ist ein Innensteg 23 vorgesehen. Am gegenüberliegenden Ende des Innensteges 23 ist ein zweiter Verbindungssteg 24 vorgesehen, welcher sich bis zu einem zweiten Außensteg 22 erstreckt. Dieser Bereich des Adapterprofils 20 kann beispielsweise durch ein entsprechendes Biegen eines Blechbauteils hergestellt werden.

In dem zweiten Außensteg 22 ist eine Befestigungsöffnung 28 vorgesehen. Mittels einer Schraube 34 ist das Adapterprofil 20 an dem Eckverbinder 18 befestigt. In ähnlicher Weise kann auch die Befestigung an dem Tiefenprofil 16 erfolgen.

In Fig. 5 ist eine Vergrößerung des Bereiches V aus Fig. 3 gezeigt. Hier ist verdeutlicht, wie das Adapterprofil 20 zum einen an dem Tiefenprofil 16 sowie an dem nichtdargestellten Eckverbinder 18 des IT-Geräteschrankes 70 befestigt wird. Dies findet wiederum über die bereits erwähnte Schraube 34 sowie über eine zweite Schraube 33 statt.

Am Eckverbinder 18 kann hierfür ein entsprechendes Gegenstück oder ein Gewinde im Eckverbinder selbst vorgesehen sein. In ähnlicher Weise kann die Befestigung an dem Tiefenprofil 16 erfolgen. Die Befestigung kann beispielsweise durch ein entsprechendes Gewinde in dem Tiefenprofil 16 realisiert sein oder mittels einem verklemmbaren Bauteil.

Abschließend ist in Fig. 6 eine Vergrößerung des Bereiches VI aus Fig. 3 gezeigt. Hier ist ersichtlich, dass die Vertikalprofile 12 sowie die Querprofile 14 dasselbe Profil aufweisen und somit denselben Querschnitt haben. So erleichtert sich die Lagerhaltung, da die entsprechenden Profile nur entsprechend abgelängt werden müssen.

Mittels des erfindungsgemäßen Erweiterungsbausatzes ist es möglich, einen IT-Geräteschrank zu verlängern und so ein größeres Schrankvolumen zu schaffen.

## Patentansprüche

1. Erweiterungsbausatz (10) für einen IT-Geräteschrank (70),
mit zwei Vertikalprofilen (12),
mit zwei Querprofilen (14),
mit vier Tiefenprofilen (16),
wobei die zwei Vertikalprofile (12) und die zwei Querprofile (14) einen rechteckigen Rahmen mit zwei unteren und zwei oberen Kontaktbereichen zwischen je einem Vertikalprofil (12) und einem Querprofil (14) ausbilden,
wobei jedes der Tiefenprofile (16) mit einem seiner Enden an einem der vier Kontaktbereiche befestigt ist,
mit zwei Adapterprofilen (20),
wobei je ein Adapterprofil (20) parallel zu je einem Vertikalprofil (12) an dem anderen Ende von zwei Tiefenprofilen (16) befestigt ist und zur Befestigung an dem IT-Geräteschrank (70) ausgebildet ist,
**dadurch gekennzeichnet,**
**dass** die Adapterprofile (20) mindestens in ihrem Anfangs- und Endbereich einen S-förmigen, gespiegelten S-förmigen, U-förmigen oder C-förmigen Querschnitt aufweisen, um in diesen Bereichen an die entsprechenden Eckverbinder des IT-Geräteschrankes (70) anbringbar zu sein.

2. Erweiterungsbausatz (10) nach Anspruch 1,
**dadurch gekennzeichnet,**
**dass** der Querschnitt der Vertikalprofile (12) und Querprofile (14) gleich ist.

3. Erweiterungsbausatz (10) nach einem der Ansprüche 1 oder 2,
**dadurch gekennzeichnet,**
**dass** in den Kontaktbereichen je ein identischer Eckverbinder (18) vorgesehen ist.

4. Erweiterungsbausatz (10) nach einem der Ansprüche 1 bis 3,
**dadurch gekennzeichnet,**
**dass** die Vertikalprofile (12), die Querprofile (14) und/oder die Tiefenprofile (16) mittels Verschraubung aneinander direkt oder indirekt befestigt sind.

5. Erweiterungsbausatz (10) nach einem der Ansprüche 1 bis 4,
**dadurch gekennzeichnet,**
**dass** der S-förmige Querschnitt der Adapterprofile (20) einen Innen- (23) und zwei Außenschenkel (21, 22) sowie zwei Verbindungsschenkel (24, 25) aufweist, dass ein erstes Ende des ersten äußeren Schenkels (21) mittels des ersten Verbindungsschenkels (24) mit einem ersten Ende des inneren Schenkels (23) verbunden ist,
**dass** ein zweites Ende des inneren Schenkels (23) mittels des zweiten Verbindungsschenkels (25) mit einem ersten Ende des zweiten äußeren Schenkels (22) verbunden ist, und
**dass** in den beiden äußeren Schenkeln (21, 22) Befestigungsöffnungen (28) vorgesehen sind.

6. Erweiterungsbausatz (10) nach Anspruch 5,
**dadurch gekennzeichnet,**
**dass** die Verbindungsschenkel (24, 25) derart dimensioniert sind, dass sie einen Zugriff auf die Befestigungsöffnungen (28) der äußeren Schenkel (21, 22) gestatten.

7. Erweiterungsbausatz (10) nach einem der Ansprüche 1 bis 6,
**dadurch gekennzeichnet,**
**dass** die Adapterprofile (20) zumindest zwischen ihrem Anfangs- und Endbereich Befestigungslöcher zur Befestigung von IT-Geräten, insbesondere nach dem HE-Standard, aufweisen.

8. IT-Geräteschrank (70) mit vier Vertikalschrankprofilen, mit vier Querschrankprofilen, mit vier Tiefenschrankprofilen sowie mit acht Eckverbindern (18), welche einen quaderförmigen Rahmen des IT-Geräteschrankes (70) ausbilden,
**gekennzeichnet durch**
einen Erweiterungsbausatz (10) nach einem der Ansprüche 1 bis 7, welcher mittels der Adapterprofile (20) an vier Eckverbindern (18) einer Front- oder Rückseite des IT-Geräteschrankes (70) befestigt ist.

9. IT-Geräteschrank (70) nach Anspruch 8,
**dadurch gekennzeichnet,**
**dass** die Vertikalprofile (12) und die Vertikalschrankprofile einen gleichen Querschnitt aufweisen, und/oder
**dass** die Querprofile (14) und die Querschrankprofile einen gleichen Querschnitt aufweisen, und/oder
**dass** die Tiefenprofile (16) und die Tiefenschrankprofile einen gleichen Querschnitt aufweisen, und/oder
**dass** die Eckverbinder (18) identisch ausgeführt sind.

## Claims

1. Extension kit (10) for an IT equipment cabinet (70),
having two vertical profiles (12),
having two transverse profiles (14),
having four depth profiles (16),
wherein the two vertical profiles (12) and the two transverse profiles (14) form a rectangular frame having two lower and two upper contact regions between one vertical profile (12) and one transverse profile (14) each,
wherein each of the depth profiles (16) is fastened to one of the four contact regions with one of its ends,
having two adapter profiles (20),
wherein one each adapter profile (20) is fastened parallel to one each vertical profile (12) on the other end of two depth profiles (16) and is designed for fastening to the IT equipment cabinet (70),
**characterised in that**
the adapter profiles (20) have, at least in their start and end regions, a S-shaped, mirrored S-shaped, U-shaped or C-shaped cross-section.so as to be attachable in these areas to the corresponding corner connectors of the IT equipment cabinet (70).

2. Extension kit (10) according to claim 1,
**characterised in that**
the cross-section of the vertical profiles (12 ) and the transverse profiles (14) is the same.

3. Extension kit (10) according to one of the claims 1 or 2,
**characterised in that**
an identical corner connector (18) is provided in each of the contact regions.

4. Extension kit (10) according to one of the claims 1 to 3,
**characterised in that**
the vertical profiles (12), the transverse profiles (14) and/or the depth profiles (16) are directly or indirectly fastened to one another by means of screwing.

5. Extension kit (10) according to one of the claims 1 - 4,
**characterised in that**
the S-shaped cross-section of the adapter profiles (20) has an inner leg (23) and two outer legs (21, 22) as well as two connecting legs (24,25),
**in that** a first end of the first outer leg (21) is connected to a first end of the inner leg (23) by means of the first connecting leg (24),
**in that** a second end of the inner leg (23) is connected to a first end of the second outer leg (22) by means of the second connecting leg (25), and
**in that** fastening openings (28) are provided in the two outer legs (21, 22).

6. Extension kit (10) according to claim 5,
**characterised in that**
the connecting legs (24, 25) are dimensioned such that they allow an access to the fastening openings (28) of the outer legs (21, 22).

7. Extension kit (10) according to one of the claims 1 to 6,
**characterised in that**
the adapter profiles (20) have, at least between their start and end regions, fastening holes for fastening IT equipment, in particular in accordance with the HE standard.

8. IT equipment cabinet (70) having four vertical cabinet profiles, having four transverse cabinet profiles, having four depth cabinet profiles as well as having eight corner connectors (18), which form a cuboid frame of the IT equipment cabinet (70),
**characterised by**
an extension kit (10) according to one of claims 1 to 7, which is fastened to four corner connectors (18) of a front or rear side of the IT equipment cabinet (70) by means of the adapter profiles (20).

9. IT equipment cabinet (70) according to claim 8,
**characterised in that**
the vertical profiles (12) and the vertical cabinet profiles have a same cross-section, and/or
**in that** the transverse profiles (14) and the transverse cabinet profiles have a same cross-section, and/or
**in that** the depth profiles (16) and the depth cabinet profiles have a same cross-section, and/or
**in that** the corner connectors (18) are designed identically.

## Revendications

1. Kit d'extension (10) pour une armoire pour équipements informatiques (70), comprenant deux profilés verticaux (12),
comprenant deux profilés transversaux (14), comprenant quatre profilés de profondeur (16),
les deux profilés verticaux (12) et les deux profilés transversaux (14) formant un cadre rectangulaire avec deux zones de contact inférieures et deux zones de contact supérieures entre respectivement un profilé vertical (12) et un profilé transversal (14),
chacun des profilés de profondeur (16) étant fixé par l'une de ses extrémités à l'une des quatre zones de contact,
comprenant deux profilés adaptateurs (20),
respectivement un profilé adaptateur (20) étant fixé parallèlement à respectivement un profilé vertical (12) à l'autre extrémité de deux profilés de profondeur (16) et étant configuré pour une fixation à l'armoire pour équipements informatiques (70),
**caractérisé en ce que**
les profilés adaptateurs (20) présentent, au moins dans leur zone initiale et leur zone terminale, une section transversale en forme de S, en forme de S inversé, en forme de U ou en forme de C, afin de pouvoir être montés dans ces zones sur les connecteurs d'angle correspondants de l'armoire pour équipements informatiques (70).

2. Kit d'extension (10) selon la revendication 1,
**caractérisé en ce que**
la section transversale des profilés verticaux (12) et des profilés transversaux (14) est identique.

3. Kit d'extension (10) selon l'une des revendications 1 ou 2,
**caractérisé en ce que**
dans les zones de contact, respectivement un connecteur d'angle identique (18) est prévu.

4. Kit d'extension (10) selon l'une des revendications 1 à 3,
**caractérisé en ce que**
les profilés verticaux (12), les profilés transversaux (14) et/ou les profilés de profondeur (16) sont fixés les uns aux autres directement ou indirectement au moyen d'un vissage.

5. Kit d'extension (10) selon l'une des revendications 1 à 4,
**caractérisé en ce que**
la section transversale en forme de S des profilés adaptateurs (20) présente une branche intérieure (23) et deux branches extérieures (21, 22) ainsi que deux branches de liaison (24, 25),
**en ce qu'**une première extrémité de la première branche extérieure (21) est reliée à une première extrémité de la branche intérieure (23) au moyen de la première branche de liaison (24),
**en ce qu'**une deuxième extrémité de la branche intérieure (23) est reliée à une première extrémité de la deuxième branche extérieure (22) au moyen de la deuxième branche de liaison (25), et
**en ce que** des ouvertures de fixation (28) sont prévues dans les deux branches extérieures (21, 22).

6. Kit d'extension (10) selon la revendication 5,
**caractérisé en ce que**
les branches de liaison (24, 25) sont dimensionnées de telle sorte qu'elles permettent un accès aux ouvertures de fixation (28) des branches extérieures (21, 22).

7. Kit d'extension (10) selon l'une des revendications 1 à 6,
**caractérisé en ce que**
les profilés adaptateurs (20) présentent, au moins entre leur zone initiale et leur zone terminale, des trous de fixation pour la fixation d'équipements informatiques, notamment selon le standard HE.

8. Armoire pour équipements informatiques (70) comprenant quatre profilés verticaux d'armoire, comprenant quatre profilés transversaux d'armoire, comprenant quatre profilés de profondeur d'armoire ainsi que huit connecteurs d'angle (18), lesquels forment un cadre parallélépipédique de l'armoire pour équipements informatiques (70),
**caractérisée par**
un kit d'extension (10) selon l'une des revendications 1 à 7, lequel est fixé au moyen des profilés adaptateurs (20) à quatre connecteurs d'angle (18) d'une face avant ou d'une face arrière de l'armoire pour équipements informatiques (70).

9. Armoire pour équipements informatiques (70) selon la revendication 8,
**caractérisée en ce que**
les profilés verticaux (12) et les profilés verticaux d'armoire présentent une section transversale identique, et/ou
**en ce que** les profilés transversaux (14) et les profilés transversaux d'armoire présentent une section transversale identique, et/ou
**en ce que** les profilés de profondeur (16) et les profilés de profondeur d'armoire présentent une section transversale identique, et/ou
**en ce que** les connecteurs d'angle (18) sont réalisés de manière identique.
